**Europäisches Patentamt**

**European Patent Office**

**Office européen des brevets**

(19)

(11) Veröffentlichungsnummer : **0 448 742 B1**

# (12) EUROPÄISCHE PATENTSCHRIFT

(45) Veröffentlichungstag der Patentschrift :
**21.06.95 Patentblatt 95/25**

(51) Int. Cl.$^6$ : **H03H 21/00**

(21) Anmeldenummer : **90105709.1**

(22) Anmeldetag : **26.03.90**

(54) **Adaptives rekursives Digitalfilter.**

(43) Veröffentlichungstag der Anmeldung :
**02.10.91 Patentblatt 91/40**

(45) Bekanntmachung des Hinweises auf die
Patenterteilung :
**21.06.95 Patentblatt 95/25**

(84) Benannte Vertragsstaaten :
**DE FR GB IT NL**

(56) Entgegenhaltungen :
**IEEE ASSP MAGAZINE, Band 6, Nr. 2, April
1989, Seiten 4-21, New York, US; J.J.SHYNK:
"Adaptive IIR filtering"**

(73) Patentinhaber : **SIEMENS
AKTIENGESELLSCHAFT
Wittelsbacherplatz 2
D-80333 München (DE)**

(72) Erfinder : **Gazsi, Lajos, Dr.
Faunastrasse 23
D-4000 Düsseldorf (DE)**

EP 0 448 742 B1

**Beschreibung**

Die Erfindung betrifft ein adaptives rekursives Digitalfilter.

Adaptive Digitalfilter sind in vielen Bereichen der zeitdiskreten Signalverarbeitung, wie beispielsweise in den Bereichen Systemanalyse, Echokompensation bei Zweidraht-Vierdraht-Übergängen, Leitungsentzerrung und Sprachverarbeitung, von großer Bedeutung. Das Charakteristikum solcher adaptiver Filter, im Vergleich zu festen Filtern, ist, daß die Filterkoeffizienten eines Übertragungsfilters, welche dessen Übertragungseigenschaften bestimmen, gegenüber einem Gütefunktional optimal eingestellt werden. Ein derartiges Gütefunktional ist etwa dadurch gegeben, daß der mittlere quadratische Fehler des Ausgangssignals des adaptiven Filters gegenüber einem Referenzsignal minimiert wird. Dabei ist es beispielsweise notwendig, die partiellen Ableitungen (Gradient) des Gütefunktionals nach den Filterkoeffizienten des Übertragungsfilters zu bilden. Für die meisten Gütekriterien ist diese Methode jedoch zurückführbar auf die Bildung der partiellen Ableitungen des Ausgangssignals des Übertragungsfilters nach den Filterkoeffizienten in einem Gradientenfilter.

Bei nichtrekursiven Strukturen, wie etwa bei Finite-Impulse-Response-Filtern oder Transversalfiltern, ist das Ausgangssignal eine Linearkombination unterschiedlich verzögerter und gewichteter Eingangssignale, wodurch die Gradientenbildung noch relativ leicht durchführbar ist. Nichtrekursive Digitalfilter sind jedoch, insbesondere bei höheren Filtergüten, mit einem erheblichen Aufwand verbunden.

Bei rekursiven Strukturen hingegen ist die Bildung des Gradienten wesentlich komplexer. Darüber hinaus sind rekursive Digitalfilter, im Gegensatz zu nichtrekursiven Digitalfiltern unter bestimmten Umständen mit Stabilitätsproblemen behaftet. Allerdings werden rekursive Strukturen nichtrekursiven Strukturen aufgrund ihres geringeren Aufwandes häufig vorgezogen.

Einen Überblick über gebräuchliche adaptive rekursive Digitalfilter gibt John J. Shynk, Adaptive IIR Filtering, IEEE ASSP Magazine, April 1989, Seite 4 ff. Dabei können zwei grundsätzliche Realisierungen unterschieden werden, nämlich eine Realisierung in direkter Form, wie beispielsweise das in FIG 12 des Artikels von Shynk gezeigte adaptive Digitalfilter, oder ein nach der Methode von Markel and Gray aufgebautes adaptives rekursives Digitalfilter, wie etwa bei Shynk in FIG 13 gezeigt. Besonders günstig bei einem in direkter Form realisierten adaptiven Digitalfilter ist, daß Nenner und Zähler der Übertragungsfunktion des Übertragungsfilters unabhängig voneinander zur Bildung des Gradienten herangezogen werden können. Jedoch ist der Stabilitätsbereich eines derartigen Filters stark eingeschränkt. Dagegen sind die Stabilitätsprobleme bei nach der Methode von Markel and Gray realisierten Digitalfiltern nur sehr gering. Bei diesen Digitalfiltern allerdings ist die Bildung der Ableitungen im Gradientenfilter jeweils sowohl vom Nenner als auch vom Zähler der Übertragungsfunktion des Übertragungsfilters abhängig.

Aufgabe der Erfindung ist es, ein adaptives rekursives Digitalfilter anzugeben, das eine hohe Stabilität und nur Ableitungen, die jeweils nur vom Nenner oder Zähler der Übertragungsfunktion des Übertragungsfilters abhängen, aufweist.

Diese Aufgabe wird durch ein adaptives rekursives Digitalfilter gemäß Patentanspruch 1 gelöst. Ausgestaltungen und Weiterbildungen des Erfindungsgedankens sind in Unteransprüchen gekennzeichnet.

Die Erfindung wird nachfolgend anhand der in den FIG der Zeichnung dargestellten Ausführungsbeispiele näher erläutert. Es zeigt:

FIG 1 eine allgemeine Ausführungsform eines erfindungsgemäßen adaptiven rekursiven Digitalfilters,

FIG 2 eine Ausführungsform eines als Wellendigitalfilter realisierten Übertragungsfilters bei einem erfindungsgemäßen adaptiven rekursiven Digitalfilter,

FIG 3 eine bevorzugte Ausführungsform eines bei einem Wellendigitalfilter nach FIG 2 angewandten Zweitoradaptors, und

FIG 4 eine Ausführungsform eines erfindungsgemäßen adaptiven rekursiven Digitalfilters zweiter Ordnung.

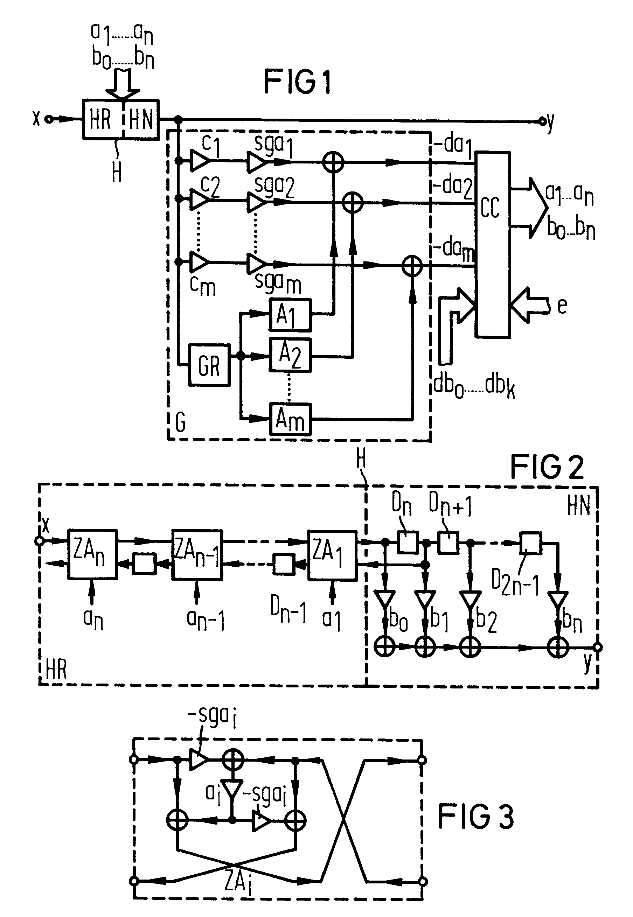

Ein erfindungsgemäßes adaptives rekursives Digitalfilter nach FIG 1 der Zeichnung weist ein Übertragungsfilter H auf, dessen Übertragungsverhalten durch veränderbare Filterkoeffizienten $a_1 \ldots a_n$ und $b_0 \ldots b_n$ festgelegt wird. An das Übertragungsfilter H ist ein Eingangssignal x angelegt, das durch dessen Übertragungsverhalten beeinflußt als Ausgangssignal y am Ausgang des Übertragungsfilters H abgegeben wird. Das Übertragungsfilter H selbst ist aufspaltbar in ein rekursives Teilfilter HR und in ein nichtrekursives Teilfilter HN, wobei dem rekursiven Teilfilter HR die Filterkoeffizienten $a_1 \ldots a_n$ und dem nichtrekursiven Teilfilter HN die Filterkoeffizien $b_0 \ldots b_n$ zugeordnet sind.

Zur Bildung des Gradienten, d.h. der Ableitungen des Ausgangssignals nach den jeweiligen Filterkoeffizienten, ist das Ausgangssignal y an ein Gradientenfilter G angelegt. Im Gradientenfilter G wird nun das Ausgangssignal y über ein rekursives Teilfilter GR, dessen Übertragungsverhalten mit dem des rekursiven Teilfilters HR des Übertragungsfilters H identisch ist - also auch identisch aufgebaut sein kann -, sowie über ein, einem bestimmten Filterkoeffizienten $a_i$ jeweils zugeordnetes, nichtrekursives Teilfilter $A_i$ geführt und anschlie-

2

ßend zu dem mit einem dem bestimmten Filterkoeffizienten $a_i$ zugeordneten Filterkoeffizienten $c_i$ und mit dem Vorzeichen $sga_i$ des bestimmten Filterkoeffizienten $a_i$ multiplizierten Ausgangssignal y addiert wird. Das Additionsergebnis stellt die Ableitung $-da_i$ des Ausgangssignals y nach dem bestimmten Filterkoeffizienten $a_i$ dar, wobei i alle Werte zwischen 1 und m annehmen kann und m kleiner oder gleich der Gesamtzahl der Filterkoeffizienten $a_1...a_n$ und $b_0...b_n$ des Übertragungsfilters H ist. Die vom Gradientenfilter G ermittelten Ableitungen $-da_1...-da_m$ und die Ableitungen $db_0... db_k$ der Übertragungsfunktion des nichtrekursiven Teilfilters HN nach den Filterkoeffizienten $b_0...b_n$, auf deren Bildung an anderer Stelle noch eingegangen wird, werden von einem Kontrollblock CC nach verschiedenen Kriterien gegenüber einem Gütefunktional e ausgewertet. Der Kontrollblock CC optimiert danach die Filterkoeffizienten $a_1...a_n$ und $b_0...b_n$ des Übertragungsfilters H und davon abhängig auch die Koeffizienten des Gradientenfilters G. Auf die Abhängigkeit der Koeffizienten bzw. des Übertragungsverhaltens des Gradientenfilters G von den Koeffizienten bzw. dem Übertragungsverhalten des Übertragungsfilters H wird ebenfalls an anderer Stelle noch eingegangen.

Eine bevorzugte Ausführungsform des Übertragungsfilters H mit einem als Wellendigitalfilter ausgebildeten rekursiven Teilfilter HR und einem als Finite-Impulse-Response-Filter ausgebildeten nichtrekursiven Teilfilter HN ist in FIG 2 der Zeichnung dargestellt. Das nichtrekursive Teilfilter HN besteht aus n in Reihe geschalteten Verzögerungsgliedern $D_n...D_{2n-1}$, deren Ausgangssignale mit jeweils einem Filterkoeffizienten $b_1...b_n$ multipliziert und anschließend aufsummiert werden. Zudem wird auch das mit dem Filterkoeffizienten $b_0$ multiplizierte Eingangssignal des ersten der in Reihe geschalteten Verzögerungsglieder - dem Verzögerungsglied $D_n$ also - mitaufsummiert. Die Gesamtsumme stellt dabei das Ausgangssignal y des Übertragungsfilters H dar.

Das Verzögerungsglied $D_n$ bildet aber auch zweckmäßigerweise das erste Verzögerungsglied des rekursiven Teilfilters HR, das aus weiteren n-1 Verzögerungsgliedern $D_1...D_{n-1}$ und n Zweitoradaptoren $ZA_1...ZA_n$ besteht. Die Zweitoradaptoren $ZA_1...ZA_n$ sind derart in Reihe geschaltet, daß sie im Vorwärtszweig direkt und im Rückwärtszweig über jeweils eines der Verzögerungsglieder $D_1...D_n$ miteinander gekoppelt sind. In den Vorwärtszweig wird beim ersten Zweitoradaptor $ZA_n$ das Eingangssignal x eingespeist. Das am Ende des Rückwärtszweiges anliegende Signal ist zur weiteren, im vorliegenden Ausführungsbeispiel jedoch nicht näher ausgeführten, Signalverarbeitung vorgesehen. Jedem der Zweitoradaptoren $ZA_1...ZA_n$ ist einer der Filterkoeffizienten $a_1...a_n$ zugeordnet.

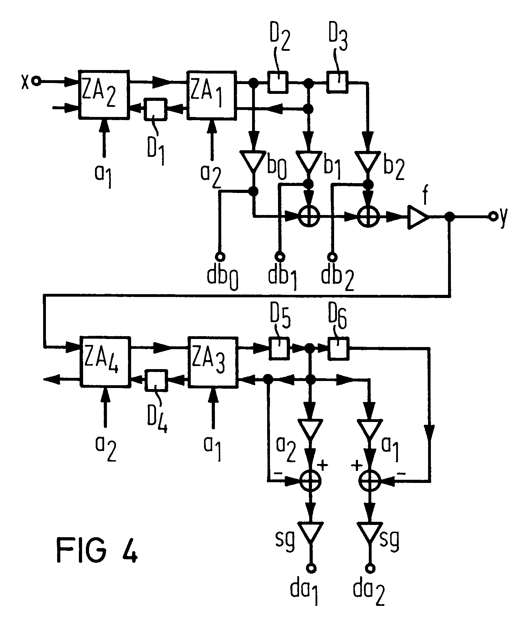

Eine bevorzugte Ausführungsform eines Zweitoradaptors $ZA_i$ gemäß FIG 3 addiert dessen Eingangssignal im Rückwärtszweig und dessen mit dem invertierten Vorzeichen des zugeordneten Filterkoeffizientten $a_i$ bewerteten Eingangssignal im Vorwärtszweig, multipliziert das Ergebnis der Addition mit dem Filterkoeffizienten $a_i$ und bildet zum einen durch Addition des Eingangssignals des Zweitoradaptors $ZA_i$ im Vorwärtszweig und des Ergebnisses der Multiplikation das Ausgangssignal des Zweitoradaptors $ZA_i$ im Rückwärtszweig und zum anderen durch Addition des Eingangssignals des Zweitoradaptors $ZA_i$ im Rückwärtszweig und des mit dem Vorzeichen des Filterkoeffizientem $a_i$ bewerteten Ergebnisses der Multiplikation das Ausgangssignal des Zweitoradaptors $ZA_i$ im Vorwärtszweig.

In FIG 4 der Zeichnung ist ein Übertragungsfilter zweiter Ordnung mit zugehörigem Gradientenfilter dargestellt. Das Übertragungsfilter weist zwei Zweitoradaptoren ZA1 und ZA2 gemäß FIG 3 im rekursiven Teilfilter auf. Die beiden Zweitoradaptoren ZA1 und ZA2 sind im Vorwärtszweig direkt und im Rückwärtszweig über das Verzögerungsglied $D_1$ miteinander gekoppelt. Die Einspeisung des Eingangssignals x erfolgt beim Zweitoradaptor ZA2. Beim Zweitoradaptor ZA1 sind Vorwärts- und Rückwärtszweig über das Verzögerungsglied $D_2$, das zudem auch die erste Stufe des nachfolgenden nichtrekursiven Teilfilters bildet, miteinander gekoppelt. Dem Verzögerungsglied $D_2$ ist ein weiteres Verzögerungsglied $D_3$ nachgeschaltet. In gleicher Weise wie das Übertragungsfilter mit den Zweitoradaptoren ZA1 und ZA2 sowie den Verzögerungsgliedern $D_1, D_2$ und $D_3$ ist das Gradientenfilter mit den Zweitoradaptoren ZA3 und ZA4 sowie den Verzögerungsgliedern $D_4, D_5$ und $D_6$ strukturiert. Auch sind den Zweitoradaptoren ZA1 und ZA3 bzw. ZA2 und ZA4 jeweils die gleichen Filterkoeffizienten $a_1$ bzw. $a_2$ zugeordnet.

Beim Übertragungsfilter werden jedoch das Eingangssignal des Verzögerungsgliedes $D_2$ und die Ausgangssignale der Verzögerungsglieder $D_2, D_3$ mit jeweils einem der Filterkoeffizienten $b_0, b_1, b_2$ multipliziert, daran anschließend aufsummiert und die Summe mit einem Faktor f multipliziert, während beim Gradientenfilter zum einen die Differenz aus dem Ausgangssignal des Verzögerungsgliedes $D_5$ und aus dem mit dem Filterkoeffizienten $a_2$ multiplizierten Ausgangssignal des Verzögerungsgliedes $D_5$ und zum anderen die Differenz aus dem Ausgangssignal des Verzögerungsgliedes $D_6$ und dem mit dem Filterkoeffizienten $a_1$ multiplizierten Ausgangssignal des Verzögerungsgliedes $D_5$ gebildet wird. Das Ausgangssignal y des Übertragungsfilters, das durch das Ergebnis der Multiplikation mit dem Faktor f gegeben ist, wird beim Zweitoradaptor ZA4 in den Vorwärtszweig des rekursiven Teilfilters des Gradientenfilters eingespeist. Die beiden im nichtrekursiven Teilfilter des Gradientenfilters gebildeten Summen entsprechen den Ableitungen des Ausgangssignals y nach dem jeweiligen Filterkoeffizienten. Da jedoch in vielen Fällen ein genauer Wert der Ableitung nicht erforderlich ist, sondern lediglich eine Tendenz, werden im vorliegenden Ausführungsbeispiel lediglich die Vor-

3

zeichen sg der jeweiligen Ableitung als Ansteuersignale $da_1$, $da_2$ für den in FIG 4 nicht dargestellten Kontrollblock verwendet.

Nachdem zuvor der strukturelle Aufbau von einigen Ausführungsformen erfindungsgemäßer adaptiver rekursiver Digitalfilter näher erläutert worden ist, wird im folgenden näher auf deren Funktionsweise und die Bestimmung der Filterkoeffizienten des Gradientenfilters eingegangen.

Filterstruktur und Bemessung der Filterkoeffizienten des Übertragungsfilters H hängen vom jeweiligen Anwendungsfall ab und werden für die weiteren Überlegungen als gegeben betrachtet. Das Übertragungsverhalten des zugrundeliegenden Digitalfilters, in diesem Falle des Wellendigitalfilters nach FIG 2, wird durch seine Übertragungsfunktion $H(a_j,b_j)$ beschrieben.

$$H(a_j,b_j) = B(b_j) \cdot K(a_j)/A(a_j) = y/x \quad (1)$$

mit

$$B(b_j) = b_0 + b_1 \cdot z^{-1} + ...b_n \cdot z^{-n}, \quad (2)$$
$$K(a_j) = (1 - |a_1|) \cdot (1 - |a_2|)....(1 - |a_n|) \quad (3)$$

und

$$A(a_j) = 1 + o_1 \cdot z^{-1} + ...o_n \cdot 2^{-n} \quad (4)$$

wobei

$$o_i(n + 1) = o_i(n) - a_{n + 1} \cdot o_{n - 1 - i}(n)$$

mit

$$i = 0,1,2,...,n + 1 \text{ und } o_0(n) = 1, o_{n + 1}(n) = 0.$$

Dabei wird das Übertragungsverhalten des nichtrekursiven Teilfilters HN durch die von den Filterkoeffizientten $b_0...b_n$ und den von den Verzögerungsgliedern $D_n...D_{2n-1}$ erzeugten Signalverzögerungen $z^{-1}...z^{-n}$ ausgehende Übertragungsfunktion $B(b_j)$ und das Übertragungsverhalten des rekursiven Teilfilters HR durch die von den Filterparametern $a_1...a_n$ und den von den Verzögerungsgliedern $D_1...D_n$ erzeugten Signalverzögerungen $z^{-1}... z^{-n}$ ausgehende Übertragungsfunktion $K(a_j)/A(a_j)$ wiedergegeben.

Filterstruktur und Bemessung der Filterkoeffizienten des Gradientenfilters ergeben sich aus der Übertragungsfunktion $H(a_j, b_j)$ des Übertragungsfilters H, in dem bei den Ableitungen des Ausgangssignales y nach den Filterkoeffizienten $a_1...a_n$, $b_0...b_n$ auf die Ableitungen der Übertragungsfunktion $H(a_j,b_j)$ nach den Filterkoeffizienten $a_1...a_n,b_0...b_n$ übergegangen wird. Es ergibt sich somit für die Ableitungen der Übertragungsfunktion $H(a_j, b_j)$ nach den Filterkoeffizienten $b_0...b_n$ des nichtrekursiven Teilfilters HN die Beziehung

$$\partial H(a_j,b_j)/\partial b_i = b_i \cdot z^{-i} \cdot K(a_j)/A(a_j) \quad (5)$$

mit

$$i = 0...n$$

und für die Ableitungen der Übertragungsfunktion $H(a_j,b_j)$ nach den Filterkoeffizienten $a_1...a_n$ des rekursiven Teilfilters HR die Beziehung

$$\partial H(a_j,b_j)/\partial a_i = H(a_j,b_j) \cdot (\partial K(a_j)/\partial a_i - HR(a_i) \cdot \partial A(a_i)/\partial a_i)/K(a_j) \quad (6)$$

mit

$$i = 1...n \text{ und } 1/K(a_j) > 0.$$

Aus den Gleichungen (5) und (6) folgt, daß für das rekursive und das nichtrekursive Teilfilter HR,HN jeweils voneinander unabhängig die Gradienten gebildet werden können. Als Gradientenfilter, das dem nichtrekursiven Teilfilter zugeordnet ist, kann dabei, wie aus Gleichung (5) zu ersehen ist, das Übertragungsfilter H selbst verwendet werden. Es entfällt lediglich bei der Gradientenbildung das Aufsummieren der mit jeweiligen Filterkoeffizienten $b_i$ multiplizierten und um $z^{-i}$ verzögerten Eingangssignale des nichtrekursiven Teilfilters, die stattdesse bei der Gradientenbildung die Ableitungen des Ausgangssignales y nach den jeweiligen Filterparametern $b_i$ wiedergeben. Bei dem Ausführungsbeispiel nach FIG 4 bilden also das Eingangs- und Ausgangssignal des Verzögerungselementes $D_2$ sowie das Ausgangssignal des Verzögerungselementes $D_3$ nach der Multiplikation mit dem jeweiligen Filterkoeffizienten $b_0,b_1,b_2$ die Ableitungen $db_i,db_1,db_2$ des Ausgangssignals y nach dem jeweiligen Filterparameter $b_0,b_1,b_2$.

Aus Gleichung (6) folgt für das dem rekursiven Teilfilter HR zugeordnete Gradientenfilter G, daß der Gradient für Zähler und Nenner der Übertragungsfunktion $HR(a_j)$ des Übertragungsfilters H wiederum voneinander unabhängig darstellbar sind, daß das Gradientenfilter G nur mit dem Ausgangssignal y des Übertragungsfilters H anzusteuern ist und daß bei der Realisierung des Gradientenfilters für den Nenner der Übertragungsfunktion $HR(a_j)$ u.a. ein identisch zu dem rekursiven Teilfilter HR des Übertragungsfilters H ausgebildetes Teilfilter mit der gleichen Übertragungsfunktion $HR(a_j)$ nötig ist. Eine grundsätzliche Struktur eines derartigen Gradientenfilters ist in dem Ausführungsbeispiel nach FIG 1 durch das Gradientenfilter G gegeben.

Zur Bestimmung der einzelnen Koeffizienten bzw. des Übertragungsverhaltens einzelner Teilfilter beim Gradientenfilter wird Gleichung (6) mit Hilfe von Gleichung (3) bzw. Gleichung (4) weiter aufgelöst:

$$\partial K(a_j)/\partial a_i = \partial(\prod_{j=1}^{n}(1-|a_j|))/\partial a_i \qquad (7)$$

$$= c_i \cdot (\partial(1-|a_i|)/\partial a_i) = -c_i \cdot sg\, a_i$$

mit

$$c_i = \prod_{j=1}^{n}(1-|a_j|)/(1-|a_j|) = \prod_{j=1}^{n}(1-|a_j|) \quad mit \quad i = j \quad (8)$$

wobei

$$i = j$$

und

$$\partial A(a_j)/\partial a_i = \partial a_1/\partial a_i \cdot z^{-1} + \partial a_2/\partial a_i \cdot z^{-2} + \ldots \partial a_n \cdot z^{-n}/a_i = A_i(a_j) = a_1 \cdot z^{-1} + \ldots + z^{-i} + \ldots a_n \cdot z^{-n} \quad (9)$$

mit

$$i,j = 1\ldots n$$

Aus der Gleichung (8) ist für die Bestimmung der Koeffizienten $c_i \ldots c_m$ zu entnehmen, daß ein bestimmter Koeffizient $c_i$ gleich dem Produkt aus allen Differenzen zwischen eins und den Beträgen der Filterkoeffizienten $a_1 \ldots a_n$ mit Ausnahme der Differenz zwischen eins und dem bestimmten Koeffizienten $a_i$ ist. Für die Teilfilter $A_1 \ldots A_m$ ergibt sich aus Gleichung (9) zum einen, daß es sich von der Struktur her um Finite-Impulse-Response-Filter handelt, und zum anderen, daß die einzelnen Koeffizienten dieser Filter gleich den Koeffizienten $a_1 \ldots a_n$ des rekursiven Teilfilters sind mit Ausnahme des bestimmten Koeffizienten $a_i$ beim Filter $A_i$, der gleich eins ist. Die Übertragungsfunktion $A_i(a_i)$ des Filters A, zeigt ebenfalls Gleichung (9).

Für ein Signal $da_i$ an den Ausgängen des Gradientenfilters G gilt dann

$$da_i = sg\,(\partial H(a_j,b_j)/\partial a_i) \quad mit \quad j = s\ldots n \quad (10),$$

wobei i alle Werte zwischen 1 und m annehmen kann und m kleiner oder gleich n ist, Das bedeutet, daß das Signal $da_i$ gleich dem Vorzeichen sg der Ableitung der Übertragungsfunktion $H(a_j,b_j)$ nach dem bestimmten Koeffizienten $a_i$ ist.

In dem Ausführungsbeispiel nach FIG 4 finden die beschriebenen grundlegenden Zusammenhänge bei einem Wellendigitalfilter zweiter Ordnung Anwendung, dem seinerseits die allgemeinen Strukturen nach FIG 2 und FIG 3 zugrundeliegen. Dabei wird in Weiterbildung der Erfindung von folgenden Überlegungen ausgegangen: Aus Gleichung (3) ergibt sich für ein gegebenes Beobachtungsintervall, unter der Annahme konstanter Koeffizienten $a_1 \ldots a_n$, deren Beträge jeweils kleiner eins sind, daß $K(a_j)$ konstant und größer null ist. Daraus folgt auch, wie bereits in Gleichung (6) erwähnt wurde, daß 1/K größer null ist. Wird nun das Ausgangssignal des Übertragungsfilters H mit einem konstanten Faktor f multipliziert, der gleich $1/K(a_j)$ ist, so ändert sich das Übertragungsverhalten nach der Multiplikation mit dem Faktor f und es kann eine gegenüber Gleichung (1) geänderte Übertragungsfunktion $H*(a_j,b_j)$ angegeben werden mit

$$H*(a_j,b_j) = y/x = B(b_j)/A(a_j) \quad (11)$$

In Bezug auf das nichtrekursive Teilfilter HN ändern sich dabei gegenüber Gleichung (5) die Koeffizienten beim Gradientenfilter nur um den konstanten Faktor f. Dagegen vereinfacht sich in Bezug auf das rekursive Teilfilter HR die Struktur des Gradientenfilters, da das dem Zähler der Übertragungsfunktion $H(a_j,b_j)$ zugeordnete Teilfilter des Gradientenfilters mit den Koeffizienten $c_1 \ldots c_m$ und $sga_1 \ldots sga_m$ aus FIG 1 entfällt. Für die Ableitungen der Übertragungsfunktion $H*(a_j,b_j)$ nach dem bestimmten Koeffizienten $a_i$ folgt dann:

$$\partial H*(a_j,b_j)/\partial a_i = (-B(b_j)/A^2(a_j)) \cdot \partial A(a_j)/\partial a_i \quad (12)$$

Für die Teilfilter $A_1$ und $A_2$ gemäß FIG 1 ergeben sich in dem Ausführungsbeispiel nach FIG 4 die Übertragungsfunktionen $A_1(a_1, a_2)$ und $A_2(a_1,a_2)$ mit

$$A_1(a_1,a_2) = \partial A(a_1,a_2)/\partial a_1 = (a_2 - 1)\cdot z^{-1} \quad (13)$$
$$A_2(a_1,a_2) = \partial A(a_1,a_2)/\partial a_2 = a_1 \cdot z^{-1} - z^{-2} \quad (14)$$

Das Teilfilter GR des Gradientenfilters G nach FIG 1 ist in FIG 4 mit den Zweitoradaptoren $ZA_3$ und $ZA_4$ sowie den Verzögerungsgliedern $D_4$ und $D_5$ dabei wiederum identisch ausgeführt wie das rekursive Teilfilter HR mit den Zweitoradaptoren $ZA_1$ und $ZA_2$ sowie den Verzögerungsgliedern $D_1$ und $D_2$.

Erfindungsgemäße adaptive rekursive Digitalfilter zeichnen sich neben einer hohen Stabilität, insbesondere bei Verwendung von Wellendigitalfiltern gemäß FIG 2 in Verbindung mit Zweitoradaptoren gemäß FIG 3 im Übertragungsfilter, durch einen geringen Syntheseaufwand, eine geringe Anzahl von Rechenoperationen sowie einem geringen apparativen Aufwand aus. Da die rekursiven Teile von Übertragungs- und Gradientenfilter identischen Aufbau aufweisen, ist bei gegebenem stabilen Übertragungsfilter auch die Stabilität des Gradientenfilters gewährleistet. Außerdem entfällt der Aufwand für die Synthese des rekursiven Teils des Gradientenfilters. Durch die Möglichkeit, Zähler und Nenner der Übertragungsfunktion des Übertragungsfilters getrennt voneinander abzuleiten, ist eine Anpassung der Übertragungscharakteristik des Filters sehr einfach durchführbar. Außerdem ist eine optimale Skalierung bei Verwendung von Zweitoradaptoren gemäß FIG 3 von Hause gegeben.

## Patentansprüche

1. Adaptives rekursives Digitalfilter
mit einem ein rekursives Teilfilter (HR) aufweisenden Übertragungsfilter (H), dessen durch eine Übertragungsfunktion beschreibbares Übertragungsverhalten mittels Filterkoeffizienten $a_1...a_n, b_0...b_n$ einstellbar ist,
mit einem Kontrollblock (CC), der abhängig von Steuersignalen $(da_1...da_m, db_0...db_k)$ die Filterkoeffizienten $a_1...,a_n, b_0...b_n$ des Übertragungsfilters (H) einstellt, und mit einem dem Übertragungsfilter (H) nachgeschalteten Gradientenfilter (G), bei dem ein vom Übertragungsfilter (H) abgegebenes Ausgangssignal (y) über eine Anzahl i mit i = 1,2,...,m, wobei m kleiner oder gleich der Gesamtanzahl der Filterkoeffizienten $a_1...a_n$ und $b_0...b_n$ ist, von Teilfiltern geführt wird und jedes Teilfilterausgangssignal mit jeweils einem bewerteten vom Übertragungsfilter (H) abgegebenen Ausgangssignal (y) aufaddiert wird, so daß jeweils die Ableitung der Übertragungsfunktion des Übertragungsfilters (H) nach jeweils einem Filterkoeffizienten $a_1...a_n, b_0...b_n$ gebildet wird und als Steuersignale $(da_1...da_m, db_0...db_k)$ für den Kontrollblock (CC) vorgesehen sind, um eine Optimierung der Filterkoeffizienten gegenüber dem Gütefunktional zu erzielen.

2. Adaptives rekursives Digitalfilter nach Anspruch 1,
**dadurch gekennzeichnet,**
daß bei dem Gradientenfilter (G) zur Bildung von Steuersignalen $(da_1...da_m)$ das Ausgangssignal (y) des Übertragungsfilters (H) über ein gemeinsames rekursives Teilfilter (GR) sowie jeweils über ein dem zugehörigen Filterkoeffizienten zugeordnetes nichtrekursives Teilfilter $(A_1...A_m)$ geführt und dazu jeweils das mit einem dem zugehörigen Filterkoeffizienten $a_1...a_m$ zugeordneten Koeffizienten $c_1...c_m$ sowie mit dem Vorzeichen $(sga_1...sga_m)$ des zugehörigen Filterkoeffizienten $a_1...a_m$ multiplizierte Ausgangssignal (y) des Übertragungsfilters (H) addiert wird,
daß das rekursive Teilfilter (GR) des Gradientenfilters (G) die gleiche Übertragungsfunktion aufweist wie das rekursive Teilfilter (HR) des Übertragungsfilters (H),
daß die nichtrekursiven Teilfilter $(A_1...A_m)$ des Gradientenfilters (G) Übertragungsfunktionen aufweisen, die jeweils gleich der Ableitung des Nenners der Übertragungsfunktion, die das rekursive Teilfilter (HR) des Übertragungsfilters (H) aufweist, nach dem zugehörigen Filterkoeffizienten $a_1...a_m$ sind, und
daß der dem zugehörigen Filterkoeffizienten $a_1...a_m$ zugeordnete Koeffizient $c_1...c_m$ jeweils gleich dem Produkt aus allen Differenzen zwischen eins und den Beträgen der Filterkoeffizienten $a_1...a_m$ mit Ausnahme der Differenz zwischen eins und dem zugehörigen Filterkoeffizienten ist.

3. Adaptives rekursives Digitalfilter nach Anspruch 1,
**dadurch gekennzeichnet,**
daß bei dem Gradientenfilter zur Bildung von Steuersignalen $(da_1, da_2)$ das Ausgangssignal des Übertragungsfilters $(ZA_1, ZA_2, D_1, D_2, a_1, a_2)$ mit einem Skalierungsfaktor (f) multipliziert und über ein gemeinsames rekursives Teilfilter $(ZA_3, ZA_4, D_4, D_5, a_1, a_2)$ sowie über jeweils ein dem zugehörigen Filterkoeffizienten zugeordnetes nichtrekursives Teilfilter $(D_5, D_6, a_1, a_2)$ geführt wird,
daß das rekursive Teilfilter $(ZA_3, ZA_4, D_4, D_5, a_1, a_2)$ des Gradientenfilters die gleiche Übertragungsfunktion aufweist wie das rekursive Teilfilter $(ZA_1, ZA_2, D_1, D_2, a_1, a_2)$ des Übertragungsfilters,
daß die nichtrekursiven Teilfilter $(D_5, D_6, a_1, a_2)$ des Gradientenfilters Übertragungsfunktionen aufweisen, die jeweils gleich der Ableitung des Nenners der Übertragungsfunktion, die das rekursive Teilfilter $(ZA_1, ZA_2, D_1, D_2, a_1, a_2)$ des Übertragungsfilters aufweist, nach den zugehörigen Filterkoeffizienten sind, und
daß der Skalierungsfaktor (f) gleich dem Kehrwert des Zählers der Übertragungsfunktion, die das rekursive Teilfilter $(ZA_1, ZA_2, D_1, D_2, a_1, a_2)$ des Übertragungsfilters aufweist, ist.

4. Adaptives rekursives Digitalfilter nach einem der Ansprüche 1 bis 3,
**dadurch gekennzeichnet,**
daß zur Steuerung des Kontrollblocks (CC) nur die Vorzeichen der Steuersignale ($da_1$,$da_2$) vorgesehen sind.

5. Adaptives rekursives Digitalfilter nach einem der Ansprüche 1 bis 4,
**dadurch gekennzeichnet,**
daß als rekursives Teilfilter (HR) des Übertragungsfilters (H) ein Zweitoradaptoren ($ZA_1$...$ZA_n$) mit jeweils zugeordneten Filterkoeffizienten $a_1$...$a_n$ und Verzögerungsglieder ($D_1$...$D_n$) aufweisendes Wellendigitalfilter vorgesehen ist.

6. Adaptives rekursives Digitalfilter nach Anspruch 5,
**dadurch gekennzeichnet,**
daß bei den Zweitoradaptoren ($ZA_1$,$ZA_n$) jeweils ein Eingangssignal im Rückwärtszweig und ein mit dem invertierten Vorzeichen des zugeordneten Filterkoeffizienten bewertetes Eingangssignal im Vorwärtszweig addiert wird, anschließend mit dem zugehörigen Filterkoeffizienten multipliziert wird und daß zum einen durch Addition des Eingangssignals im Vorwärtszweig und des Ergebnisses der Multiplikation das Ausgangssignal im Rückwärtszweig und zum anderen durch Addition des Eingangssignals im Rückwärtszweig und des mit dem Vorzeichen des zugehörigen Filterkoeffizienten bewerteten Ergebnisses der Multiplikation das Ausgangssignal im Vorwärtszweig gebildet wird.

## Claims

1. Adaptive, recursive digital filter,
having a transmission filter (H), which has a recursive subfilter (HR) and whose response, which can be described by a transfer function, can be adjusted by means of filter coefficients $a_1$..$a_n$,$b_0$...$b_n$,
having a control block (CC), which adjusts the filter coefficients $a_1$...$a_n$,$b_0$...$b_n$ of the transmission filter (H) as a function of control signals ($da_1$...$da_m$,$db_0$...$db_k$), and
having a gradient filter (G), which is connected downstream of the transmission filter (H) and in which an output signal (y) emitted by the transmission filter (H) is fed via a number i of subfilters, i being equal to 1, 2, ..., m, where m is less than or equal to the total number of filter coefficients $a_1$...$a_n$ and $b_0$...$b_n$, and each subfilter output signal is added in each case to a weighted output signal (y) emitted by the transmission filter (H), with the result that the derivative of the transfer function of the transmission filter (H) is in each case formed in accordance with a respective filter coefficient $a_1$...$a_n$,$b_0$...$b_n$, these derivatives being provided as control signals ($da_1$...$da_m$,$db_0$...$db_k$) for the control block (CC), in order to achieve optimization of the filter coefficients with respect to the quality function.

2. Adaptive, recursive digital filter according to Claim 1, characterized in that, in the gradient filter (G) for forming control signals ($da_1$...$da_m$), the output signal (y) of the transmission filter (H) is fed via a common recursive subfilter (GR) and via a respective non-recursive subfilter ($A_1$...$A_m$), which is assigned to the associated filter coefficient, and to this signal there is added in each case the output signal (y) of the transmission filter (H) multiplied by a coefficient $c_1$...$c_m$, assigned to the associated filter coefficient $a_1$...$a_m$, and by the sign ($sga_1$...$sga_m$) of the associated filter coefficient $a_1$...$a_m$,
in that the recursive subfilter (GR) of the gradient filter (G) has the same transfer function as the recursive subfilter (HR) of the transmission filter (H), in that the non-recursive subfilters ($A_1$...$A_m$) of the gradient filter (G) have transfer functions which are in each case equal to the derivative of the denominator of the transfer function of the recursive subfilter (HR) of the transmission filter (H), in accordance with the associated filter coefficient $a_1$...$a_m$, and
in that the coefficient $c_1$...$c_m$ assigned to the associated filter coefficient $a_1$...$a_m$ is in each case equal to the product of all the differences between one and the values of the filter coefficients $a_1$...$a_m$, with the exception of the difference between one and the associated filter coefficient.

3. Adaptive, recursive digital filter according to Claim 1, characterized in that, in the gradient filter for forming control signals ($da_1$,$da_2$), the output signal of the transmission filter ($ZA_1$,$ZA_2$,$D_1$,$D_2$,$a_1$,$a_2$) is multiplied by a scaling factor (f) and fed via a common recursive subfilter ($ZA_3$,$ZA_4$,$D_4$,$D_5$,$a_1$,$a_2$) and via a respective non-recursive subfilter ($D_5$,$D_6$,$a_1$,$a_2$), assigned to the associated filter coefficient,
in that the recursive subfilter ($ZA_3$,$ZA_4$,$D_4$,$D_5$,$a_1$,$a_2$) of the gradient filter has the same transfer function as the recursive subfilter ($ZA_1,ZA_2,D_1,D_2,a_1,a_2$) of the transmission filter, in that the non-recursive subfilters ($D_5,D_6,a_1,a_2$) of the gradient filter have transfer functions which are in each case equal to the derivative of the denominator of the transfer function of the recursive subfilter ($ZA_1,ZA_2,d_1,d_2,a_1,a_2$) of the transmission filter, in accordance with the associated filter coefficients, and in that the scaling factor (f) is equal to the reciprocal of the numerator of the transfer function of the recursive subfilter ($ZA_1,ZA_2,D_1,D_2,a_1,a_2$) of the transmission filter.

4. Adaptive, recursive digital filter according to one of Claims 1 to 3, characterized in that only the signs of the control signals ($da_1,da_2$) are provided for the purpose of controlling the control block (CC).

5. Adaptive, recursive digital filter according to one of Claims 1 to 4, characterized in that a digital wave filter is provided as the recursive subfilter (HR) of the transmission filter (H), which digital wave filter has two-gate adapters ($ZA_1...ZA_n$), which have respectively assigned filter coefficients $a_1...a_n$ and delay elements ($D_1...D_n$).

6. Adaptive, recursive digital filter according to Claim 5, characterized in that, in the two-gate adapters ($ZA_1,ZA_n$), an input signal in the backward path and an input signal in the forward path, which is weighted with the inverted sign of the assigned filter coefficient, are in each case added and then multiplied by the associated filter coefficient, and in that, firstly, the output signal in the backward path is formed by addition of the input signal in the forward path and the result of the multiplication, and, secondly, the output signal in the forward path is formed by addition of the input signal in the backward path and the result of the multiplication, said result being weighted with the sign of the associated filter coefficient.

## Revendications

1. Filtre numérique adaptatif récursif comportant un filtre de transmission (H) ayant un filtre partiel récursif (HR) et dont le comportement de transmission, qui peut être décrit par une fonction de transfert, est réglable au moyen de coefficients de filtre $a_1...a_n$, $b_0...b_n$, un bloc de contrôle (CC), qui, en fonction de signaux de commande ($da_1...da_m$, $db_0...db_k$), règle les coefficients $a_1...a_n$, $b_0...b_n$ du filtre de transmission (H), et un filtre à gradient (G), branché en aval du filtre de transmission (H) et dans lequel un signal de sortie (y), fourni par le filtre de transmission (H), est transmis par l'intermédiaire d'un nombre i de filtres partiels, $i = 1,2,..., m$ et m étant inférieur ou égal au nombre total des coefficients de filtre $a_1...a_n$ et $b_0...b_n$, et à chaque signal de sortie d'un filtre partiel est additionné un signal de sortie (y) pondéré et fourni par le filtre de transmission (H), de sorte à former la dérivée de la fonction de transfert du filtre de transmission (H) par rapport à chaque coefficient de filtre $a_1...a_n$, $b_0...b_n$, et à prévoir ces dérivées en tant que signaux de commande ($da_1...da_m$, $db_0...db_k$) pour le bloc de contrôle (CC) pour obtenir une optimisation des coefficients de filtre par rapport à la fonction de qualité.

2. Filtre numérique adaptatif récursif suivant la revendication 1, caractérisé par le fait que dans le filtre à gradient (G) destiné à la formation de signaux de commande ($da_1...da_m$), le signal de sortie (y) du filtre de transmission (H) passe par un filtre partiel récursif commun (GR) ainsi que par un filtre partiel non récursif $A_1...A_m$ affecté au coefficient de filtre associé, et aux signaux obtenus est additionné le signal de sortie (y) du filtre de transmission (H), qui est multiplié par un coefficient ($c_1...c_m$), qui est affecté au coefficient de filtre associé $a_1...a_m$, et par le signe ($sga_1...sga_m$) du coefficient de filtre $a_1...a_m$ associé, que le filtre partiel récursif (GR) du filtre à gradient (G) a la même fonction de transfert que le filtre partiel récursif (HR) du filtre de transmission (H), que les filtres partiels non récursifs ($A_1...A_m$) du filtre à gradient (G) ont des fonctions de transfert, qui sont égales à la dérivée du dénominateur de la fonction de transfert, qu'a le filtre partiel récursif (HR) du filtre de transmission (H), par rapport au coefficient de filtre associé $a_1...a_m$, et que le coefficient $c_1...c_m$, qui est affecté au coefficient de filtre associé $a_1...a_m$, est égal au produit de toutes les différences entre un et les modules des coefficients de filtre $a_1...a_m$, à l'exception de la différence entre un et le coefficient de filtre associé.

3. Filtre numérique adaptatif récursif suivant la revendication 1, caractérisé par le fait

que dans le cas du filtre à gradient destiné à la formation de signaux de commande ($da_1$, $da_2$), le signal de sortie du filtre de transmission ($ZA_1$, $ZA_2$, $D_1$, $D_2$, $a_1$, $a_2$) est multiplié par un facteur d'échelle (f) et est transmis par l'intermédiaire d'un filtre partiel récursif commun ($ZA_3$, $ZA_4$, $D_4$, $D_5$, $a_1$, $a_2$) ainsi que par l'intermédiaire d'un filtre partiel non récursif ($D_5$, $D_6$, $a_1$, $a_2$), affecté au coefficient de filtre associé,

que le filtre partiel récursif ($ZA_3$, $ZA_4$, $D_4$, $D_5$, $a_1$, $a_2$) du filtre à gradient a la même fonction de transfert que le filtre partiel récursif ($ZA_1$, $ZA_2$, $D_1$, $D_2$, $a_1$, $a_2$) du filtre de transmission,

que les filtres partiels non récursifs ($D_5$, $D_6$, $a_1$, $a_2$) du filtre à gradient ont des fonctions de transfert, qui sont égales à la dérivée du dénominateur de la fonction de transfert, qu'a le filtre partiel récursif ($ZA_1$, $ZA_2$, $D_1$, $D_2$, $a_1$, $a_2$) du filtre de transmission, par rapport aux coefficients de filtre associés, et

que le facteur d'échelle (f) est égal à l'inverse de la valeur du numérateur de la fonction de transmission, qu'a le filtre récursif partiel ($ZA_1$, $ZA_2$, $D_1$, $D_2$, $a_1$, $a_2$) du filtre de transmission.

4. Filtre numérique adaptatif récursif suivant l'une des revendications 1 à 3, caractérisé par le fait que seuls les signes des signaux de commande ($da_1$, $da_2$) sont prévus pour la commande du bloc de contrôle (CC).

5. Filtre numérique adaptatif récursif suivant l'une des revendications 1 à 4, caractérisé par le fait qu'il est prévu, comme filtre partiel récursif (HR) du filtre de transmission (H), un filtre numérique d'ondes, qui comporte des adaptateurs à deux portes ($ZA_1$...$ZA_n$), auxquels sont associés respectivement des coefficients de filtre $a_1$...$a_n$, et des circuits de retardement ($D_1$...$D_n$).

6. Filtre numérique adaptatif récursif suivant la revendication 5, caractérisé par le fait que dans les adaptateurs à deux portes ($ZA_1$, $ZA_n$), un signal d'entrée est additionné dans la branche rétrograde et un signal d'entrée pondéré par le signe inversé du coefficient de filtre associé, est additionné dans la branche directe, puis est multiplié par le coefficient de filtre associé, et que d'une part le signal de sortie dans la branche rétrograde est formé par addition du signal d'entrée présent dans la branche directe et du résultat de la multiplication, et que d'autre part le signal de sortie dans la branche directe est formé par addition du signal d'entrée dans la branche rétrograde et du résultat de la multiplication, pondéré par le signe du coefficient de filtre associé.

FIG 1

FIG 2

FIG 3

FIG 4